# EUROPEAN PATENT SPECIFICATION

(11) **EP 0 573 254 B1**
(45) Date of publication and mention of the grant of the patent: **28.10.1998**
(21) Application number: 93304239.2
(22) Date of filing: 01.06.1993
(51) Int. Cl.: H05K 5/00

(54) **Housing for control unit**
Gehäuse für Steuereinheit
Boîtier pour une unité de commande

(30) Priority: 03.06.1992 GB 9211703
(43) Date of publication of application: 08.12.1993
(73) Proprietor: Delmatic Limited, London W1P 5PN (GB)
(72) Inventor: Woodnutt, John, Near Cranbrook, Kent TN18 5PE (GB)
(74) Representative: Brereton, Paul Arthur

(56) References cited:
- DE-A- 3 506 860
- DE-U- 7 141 337
- DE-U- 7 539 709
- GB-A- 699 550

## Description

The present invention relates to housings for electrical components and is concerned especially, but not exclusively with housings for controlled switched outlets for lighting installations.

A lighting installation may include units providing a number of socket outlets into which electrical plug connectors may be fitted. The outlets may be fed from the mains power supply via relays which may be operated by electrical control signals locally or from a remote location. The components of the unit may be housed in a housing consisting of a cover and a base part, both of which are formed from bent sheet metal.

For installation and repair it is necessary that the cover can be removed from the base to allow access to the interior of the housing. Screws may be used for securing the cover to the base, but they can make the operations of mounting and dismounting the cores to the base time-consuming, which is particularly undesirable in a large lighting installation where many units may be fitted.

GB 921293 teaches a latching arrangement comprising a T-shaped tab and a corresponding slot of larger and shorter portions.

A latch type fastening arrangement might be used for holding the cover to the base of a housing for an electrical component as follows T-shaped tabs are formed on the walls of the base which cooperate with slots in the cover to form the latching arrangement. The slots have portions of longer and shorter length alongside one another. The T-shaped tabs can be flexed to allow their cross-pieces to be inserted through the longer portion of the slot, and then released to allow the stems of the T-shaped tabs to enter the portion of the slot of shorter length. In this position the cross-pieces are hooked over the parts of the cover surrounding the slot and thus the cover is held in position.

The slots and the tabs can be stamped out from the metal sheet which forms the cover and the base and are thus simple and inexpensive to manufacture. The fastening may be released simply by flexing the tabs outwardly, usually by means of a screwdriver, to allow the cross-pieces to pass through the longer portions of the slots.

A disadvantage of the arrangement described above is that the tabs project above the tops of the walls of the base and are thus quite exposed. Being cut from sheet metal, they are sharp and could easily cause injury to the operators installing or repairing the units, or damage clothing.

DE-U-7141337 describes a housing for an electrical component comprising a cover, a base and means for fastening the cover to the base.

According to the present invention in a first aspect a housing for an electrical component is provided in accordance with Claim 1.

In one possible arrangement which is not part of the invention the portion of shorter length is outermost with respect to the housing so that the tabs are flexed inwardly to pass through the longer portion of the slots. A further portion of even shorter length is provided outside the shorter portion, for receiving the tip of a screwdriver to assist in levering the tabs to flex them inwardly when dismantling the housing.

We have found that when the fastening arrangement is set below the level of the top wall of the cover, the peripheral wall of the cover may obstruct the movement of the screwdriver in the direction necessary to lever the tab out of the shorter portion of the slot, if the longer portion is on the inside.

In accordance with of the invention the longer portions of the slots are on the side of the shorter portions which is furthest from the peripheral side wall of the cover. with this arrangement the handle of the screwdriver is moved away from the housing when the tab is being levered out of the shorter portion of the slot.

We have also found that a more reliable fastening of the cover to base is achieved if means are provided for locating the cover relative to the base in the transverse direction.

According to the present invention is a second aspect, a housing for an electrical component is provided in accordance with claim 7.

In a preferred form of the invention the means for locating to cover relative to the base comprise electrical pin-and-socket connectors mounted on the cover and base respectively for providing electrical connections between the base and electrical components mounted on the cover.

The positive location of the cover relative to the base provided by the pin-and-socket connection helps to ensure that transverse movement of the cover relative to the base which would enable the T-shaped tabs to become unfastened accidentally, is prevented.

Some lateral movement of the sockets relative to the cover or base may be permitted to accommodate variations in positioning of the pins, but such movement is limited, and less than the lateral movement which would enable the T-shaped tabs means to become unfastened. Typically, permitted lateral movement of the socket is less than about 0.5 mm whereas a movement of about 1.5 mm is required to unfasten the T-shaped tabs.

Preferably the pins are round pin plugs which fit in sockets of rectangular or hexagonal cross-section when the cover is lowered on to the base.

Preferably the sockets are mounted in cavities in an insulating member fixed to the base and each socket is of a smaller dimensions than the cavity in which it sits so that it can move to a limited extend, typically about 0.5 mm, to accommodate small variations in the positioning of the pins.

The earth socket and plug may be closer to one another than the other sockets and plugs, when the cover and base are separated so that they will be the first to make contact.

Preferably the sockets are mounted on the base and are formed in electrically conductive members which form the terminals.

Preferably the terminals are each formed by a wire receiving hole passing transversely through the electrically conductive member and a grub screw in a tapped hole at the bottom of the socket, which tapped hole intersects with the wire-receiving hole.

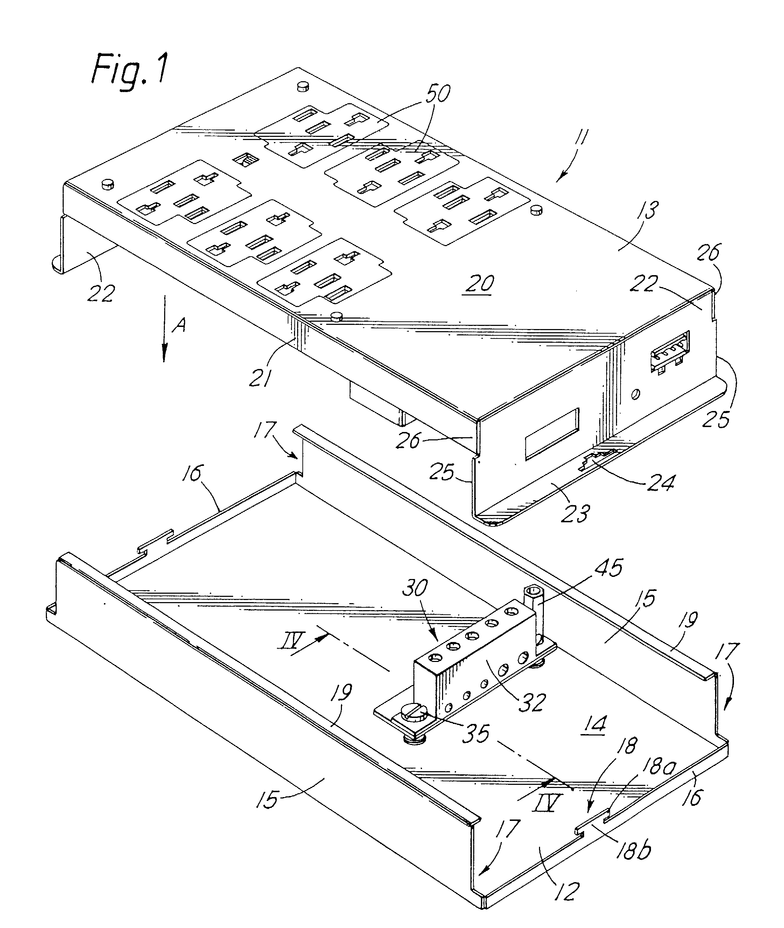

An embodiment of the invention will now be described by way of example with reference to the accompanying drawings of which:-
Figure 1 shows an exploded perspective view of a housing in accordance with the invention;

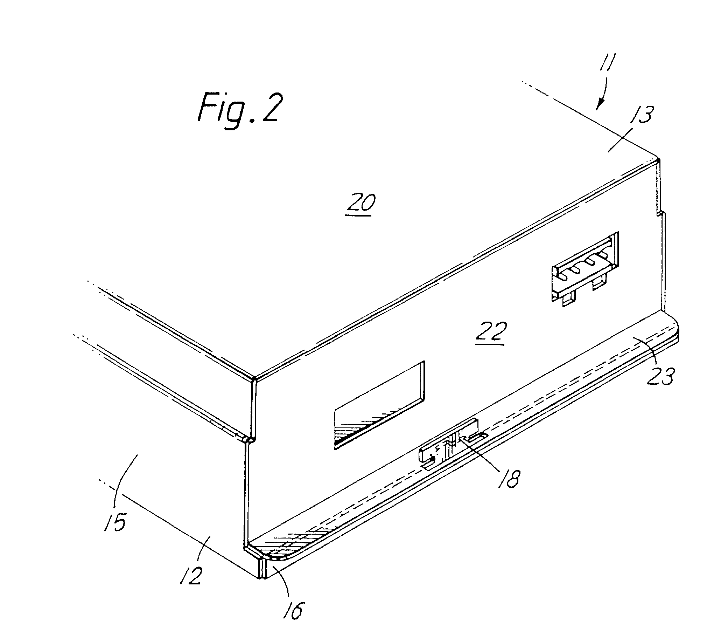

Figure 2 shows a fragmentary perspective view of the housing with the components assembled;

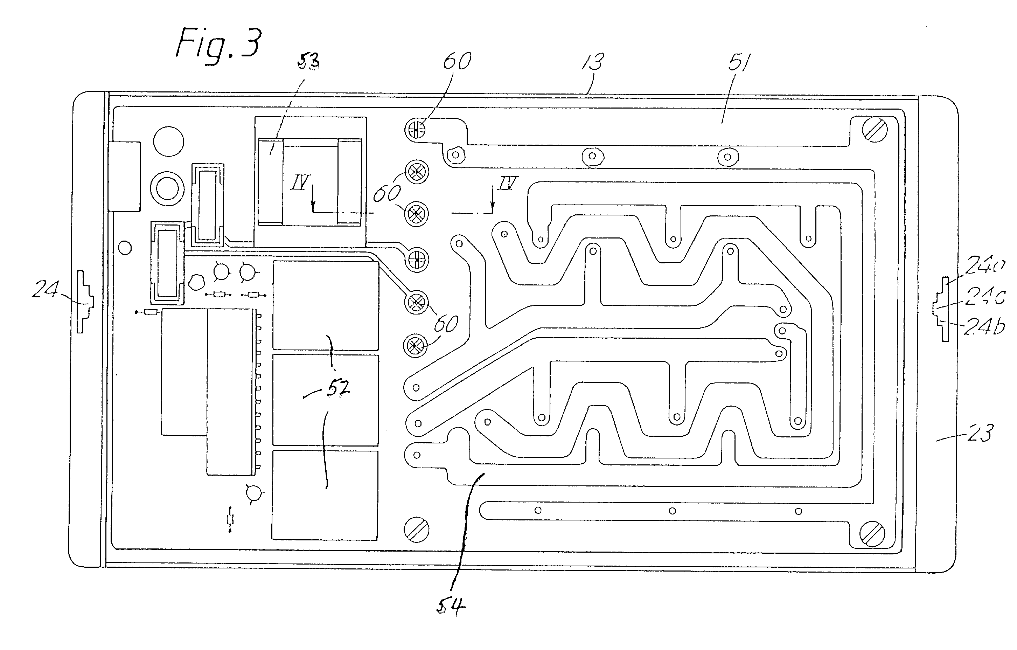

Figure 3 shows an underneath plan view of the cover of the housing of Figures 1 and 2;

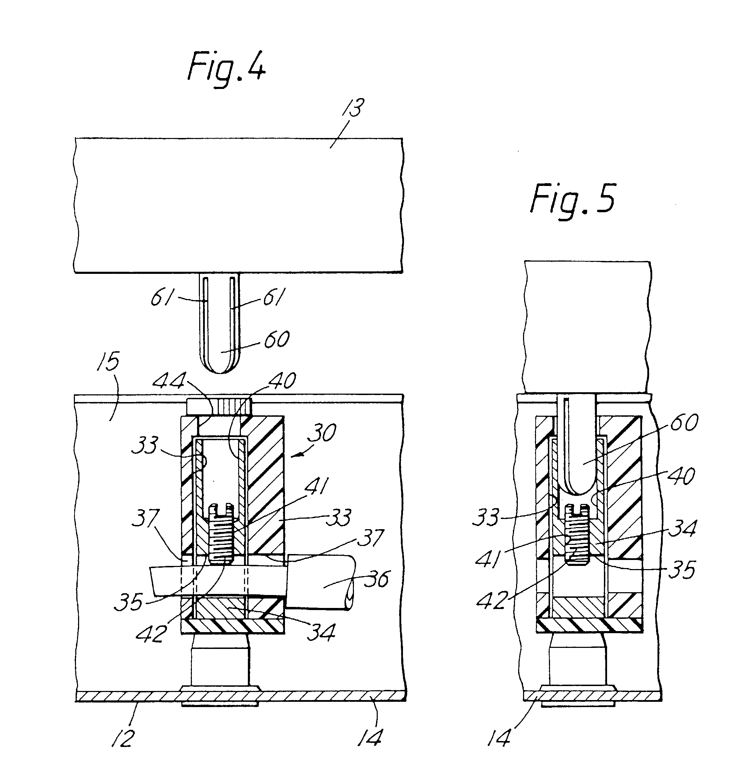

Figure 4 shows an exploded cross-sectional view along the lines IV-IV; and
Figure 5 shows a cross-section similar to Figure 4 with the parts assembled.

A housing 11 for electrical components, in this case socket outlets with remote controlled switches for a lighting system comprises a base 12 and a cover 13, both bent from sheet metal.

The base consists of a bottom wall 14, side walls 15, and end walls 16. The side walls and end walls are bent up from the bottom wall. The end walls 16 extending only a short distance above the bottom wall, are substantially lower than the side walls 15. A portion of each side wall adjacent the end wall is cut back to the same height as the end walls to form a recess 17. A T-shaped tab 18 projects upwardly from the centre of each end wall 16. The upper edges of the side walls 15 are bent inwardly towards one another to form flanges 19.

The cover 13 comprises a top wall 20, side walls 21 and end walls 22. The side walls and end walls are bent from the top wall. The end walls 22 are substantially higher than the side walls 21.

The lower edge of each end wall 22 of the cover 20 is bent outwardly at right angles to form a flange 23. A slot 24 is cut in each flange 23 and has its major axis extending parallel to the end wall 22. Each slot 24 gets narrower from the outer edge of the flange 23 towards the end wall 22 in a stepwise manner. There are thus three portions of different lengths forming each slot 24, an outer portion 24a of greater length than the length of the top cross portion 18a of the T-shaped tab 18, a middle portion of length shorter than the width of the T-shaped tab 18 but greater than the width of the lower portion 18b of the T-shaped tab, and an inner portion 24c of smaller length than the width of the lower portion 18b of the T-shaped tab. The T-shaped tabs 18 and the slots 24 co-operate to form a latching mechanism for securing the cover to the base in a manner that will be described.

The lower edges of the side walls 21 and the cover 13 are bent inwardly towards one another to form flanges (not shown) which abut the flanges 19 on the base when the cover is slid towards the base in the direction of the arrow "A" and the flanges 23 abut the upper edge of the end walls 16.

The spacing of the end walls 22 of the cover from one another is such that they slide into the recess 17 in the side walls 15 of the base when the cover is moved towards the base in the direction of the arrow "A". The length of the end walls 22 is the same as the outside dimension of the base measured along the end walls so that the outer edges 25 of the end walls are flush with the outsides of the side walls 15.

The upper portions of the outer edges of the end walls are cut back at 26 and the outer surfaces of the side walls 21 the cover are flush with these cut back portions. In this way, when the housing is mounting alongside trunking accommodating supply cables, there is a small clearance between the upper portion of the cover of the housing and the trunking.

To fit the cover to the base, it is moved towards the base in the direction of the arrow "A" with the edges 25 sliding down the vertical edges of the side walls that bound the recesses 17. The tabs 18 are flexed outwardly by hand so as to enable them to pass through the longest outer portion 24a of the slots 24. When the flanges 23 abut the upper edge of the end wall 16 and the flanges on the underside of the side walls 21 of the cover 20 abut the flanges 19, the cross pieces 18a of the T-shaped tabs have passed through the slot and the lower stem portion 18b of the tabs can enter the intermediate portion 24b of the slot 24 under the resilient action of the end walls. The upper cross-portion 18a of the tab overlaps the portion of the flange 23 of the cover surrounding the slot so as to hold the cover in position.

To release the cover from the base a screwdriver is inserted into the narrowest inner portion of the slot 24c and the handle is swung outwardly to lever the tab so that it is aligned with the longest portion 24c of the slot 24. The tab 18 is now in a position where its upper cross-portion 18a can pass through the longest portion 24c of the slot and the cover can thus be lifted away from the base.

A terminal block 30 of insulating material, for example plastics, is mounted on the bottom wall 14 of the base by screws 31. The block includes a rectangular housing portion 32 which includes a plurality of rectangular cavities 33 (in this case five). Each cavity 33 accommodates a rectangular terminal post 34 of electrically conductive material, for example brass. Each terminal post fits in its cavity with a clearance space between the outside of the terminal post and the inner wall of the cavity so that limited transverse movement of the post in the cavity is permitted in the plane of the bottom wall 14. Typically the clearance is about 0.5 mm in both directions, or less. A transverse hole 35 passes through each of the five terminal posts for receiving a bared end of a respective wire 36. Five transverse holes 37 pass through the opposite walls of the terminal housing 32 and are aligned with the holes 35 in the terminal posts to allow the wires 36 to reach the holes 35 in the terminal posts 34. The holes in the terminal housing and the terminal posts are parallel to one another and to the bottom wall 14 and side walls 15 of the base. In this way, the holes in the housing and terminal posts are conveniently positioned for cables passing into the box from the hole (not shown) in the side wall of the base.

A socket 40 is formed in the upper end of each terminal post 34 and has a circular horizontal cross-section. A screw-threaded hole 41 is formed at the bottom of each socket and extends into the transverse hole 35 in the post. The hole 41 receives a grub screw 42, which can be turned by a screwdriver inserted into the socket 40, for securing the bared end of the wire in position. Five holes 44 are formed in the top of the housing and aligned with the sockets 40 of the five terminals, for access.

For ease of moulding, the terminal block 30 is formed in two parts, an upper part 30a which forms the housing 32 and includes the cavities 33, and a flat lower part 30b which extends outwardly beyond the housing 32 and has holes for receiving the mounting screws 31. The lower part provides the lower walls to the cavities 33. The two parts of the terminal block are secured together by welding or adhesive. A sixth terminal post 45, similar to the terminal posts 34, is secured to the lower portion of the terminal block 30b outside the housing 32 for receiving the earth wire (not shown).

The cover 13 has openings in its top wall 20 for receiving electrical sockets 50 for a lighting system. A circuit board 51 is mounted on the underside of the top wall and carries various electrical components including relays 52, a transformer 53 and electrical connecting tracks between the various components 54.

Six round contact pins 60 are mounted on the underside of the circuit board and project downwardly at right angles from it. The contact pins are connected electrically to the circuitry of the circuit board 51. They are each made of conductive material, for example brass, and their lower ends are rounded and split by two intersecting slots 61 for resilience.

The contact pins 60 are arranged in a straight line in positions which correspond with the positions of the sockets in the terminal posts of the terminal block 30. When the cover 13 is lowered onto the base 12 the pins 60 pass through the holes 44 in the top of the housing 32 and into the sockets 40 of the terminal posts 34 to establish electrical connections from the wires 36 attached to the terminal posts to the circuitry on the cover 13.

By permitting the terminal blocks to move transversely a limited amount in the plane of the bottom wall 14, variation in the positioning of the pins on the circuit board within relatively large tolerances can be accommodated. The inter-engagement of the pins with the sockets also serves to locate the cover relative to the base in the transverse direction, in the transverse direction parallel to the top wall 20 relative to the base. The pin and socket connections co-operate with the tab and slot latching arrangement to ensure a more reliable fastening of the cover to the base. Without the positive location provided by the pin and socket arrangement, small relative movement between the base and cover in a direction parallel to the bottom and side walls would allow the tabs to become unhooked from the slots 24. The inter-engagement of the pin and sockets limits the relative movement of the cover and base and prevents the latching mechanism from becoming accidentally unhooked. Although the sockets are allowed to move up to about 0.5 mm transversely within the cavities, this movement is not sufficient for the latching arrangement to become unhooked which requires a movement of about 1.5 mm.

The present invention thus provides a simple inexpensive and reliable arrangement for fastening together the cover and base of a housing.

## Claims

1. A housing (1) for an electrical component, comprising a base (12) and a cover (13), the base including a bottom wall (14) and peripheral walls (15 and 16) extending upwardly from the bottom wall (14), at least two T-shaped tabs (18) projecting upwardly from the base (12), and the cover having a top wall (13) and peripheral walls (21 and 22) projecting downwardly from the top wall (13), slots (24) being formed in the cover and positioned to cooperate with the T-shaped tabs (18), each slot (24) including portions (24a and 24b) of longer and shorter length arranged side by side, the length of the longer portion (24a) being greater than the length of the cross-piece (18a) of the corresponding T-shaped tab (18) and the length of the shorter portion (24b) being less than the length of the cross-piece (18a) but greater than the width of the stem (18b) of the T-shaped tab (18), the peripheral wall (16) of the base is lower in the region of the T-shaped tabs, the tops of the tabs (18) are lower than the top of the peripheral wall (15) of the base at its highest point (19), the slots (24) are formed on flanges (23) extending from the bottom of the peripheral side walls of the cover (13), whereby the fastening arrangement formed by the slots (24) and tabs (18) is set below the level of the top of the base, and the longer portion of the slots are on the side of the shorter portions which is furthest from the peripheral side wall of the cover.

2. A housing according to Claim 1, characterised in that means (60 and 40) are provided for locating the cover (13) relative to the base (12) in the transverse direction.

3. A housing according to claim 2, characterised in that the means for locating the cover relative to the base comprise electrical pin-and-socket connectors (60 and 40) mounted on the cover and base respectively for providing electrical connections between the base and electrical components mounted on the cover.

4. A housing according to Claim 3, characterised in that in which the sockets (40) are mounted in cavities (33) in an insulating member (30) fixed to the base (12) and each socket (40) is of a smaller dimensions than the cavity (33) in which it sits so that it can move to a limited extend to accommodate small variations in the positioning of the pins (60).

5. A housing according to Claim 3 or 4, characterised in that the pins (60) are round pin plugs which fit in sockets of rectangular or hexagonal cross-section when the cover is lowered on to the base.

6. A housing according to Claim 4 or 5, characterised by an earth socket (45) and an earth plug (60) on the cover and base respectively and in which the earth socket (45) and plug (60) are closer to one another than the other sockets (40) and plugs (60) when the cover and base are separated, so that they will be the first to make contact when the cover (13) is lowered onto the base (12).

7. A housing for an electrical component, comprising a base (12) and a cover (13), latching means for securing the cover to the base, electrical components (50 to 54) being mounted on the cover (13) and terminals (34) for connection to electrical supply cables being mounted on the base (12), pin and socket connectors (60 and 40) being provided with the pin (60) on the base (12) or cover (13) and the socket (40) on the cover or base respectively, the pin and socket connectors serving to locate the cover (13) relative to the base (12) in the transverse direction and also to provide electrical connections between the components (50 to 54) and the terminals (34) when the cover (13) is fitted to the base (12), the means for securing the cover to the base comprise latching means in the form of at least two T-shaped tabs (18) projecting upwardly from said base (12) which are engageable in respective slots (24) formed on flanges (23) extending from the bottom of the peripheral side walls of the cover (13), the peripheral wall of the base being lower in the region of the T-shaped tabs, the tops of the tabs (18) being lower than the top of the peripheral wall (15) of the base at its highest point (19), whereby the fastening arrangement formed by the slots (24) and the tabs (18) is set below the level of the top of the base, and the longer portions of the slots are on the side of the shorter portions which is furthest from the peripheral side wall of the cover, the sockets (40) are mounted in cavities (33) in an insulating member (30) fixed to the base (12) or cover (13), and each socket (40) is of smaller dimensions than the cavity in which it sits so that it can move to a limited extent to accommodate small variations in the positioning of the pins (60), the lateral movement being limited and less than the lateral movement which would enable the T-shaped tabs to become unfastened.

## Patentansprüche

1. Gehäuse (1) für ein elektrisches Bauteil, umfassend einen Boden (12) und einen Deckel (13), wobei der Boden eine untere Wand (14) und sich von der unteren Wand (14) nach oben erstreckende Umfangswände (15 und 16) hat, wobei mindestens zwei T-förmige Ansätze (18) vom Boden (12) nach oben ragen, und der Deckel eine obere Wand (13) und von der oberen Wand (13) nach unten ragende Umfangswände (21 und 22) hat,.wobei in den Deckel Schlitze (24) eingeformt und zum Zusammenwirken mit den T-förmigen Ansätzen (18) positioniert sind, wobei jeder Schlitz (24) nebeneinander angeordnete Teile (24a und 24b) längerer und kürzerer Länge hat, wobei die Länge des längeren Teils (24a) größer ist als die Länge des Querstücks (18a) des entsprechenden T-förmigen Ansatzes (18) und die Länge des kürzeren Teils (24b) geringer ist als die Länge des Querstücks (18a), aber größer als die Breite des Schafts (18b) des T-förmigen Ansatzes (18), dadurch gekennzeichnet, daß die Umfangswand (16) des Bodens im Bereich der T-förmigen Ansätze niedriger ist, daß die Oberseite der Ansätze (18) niedriger ist als die Oberseite der Umgebungswand (15) des Bodens an ihrem höchsten Punkt (19), daß die Schlitze (24) in sich von der Unterseite der Umfangsseitenwände des Deckels (13) erstreckenden Flanschen (23) geformt sind, wodurch die von den Schlitzen (24) und Ansätzen (18) gebildete Befestigungsanordnung unter der Höhe der Oberseite des Bodens angeordnet ist, und daß sich der längere Teil der Schlitze auf der Seite der kürzeren Teile befindet, die sich am weitesten von der Umfangsseitenwand des Deckels entfernt befindet.

2. Gehäuse nach Anspruch 1, dadurch gekennzeichnet, daß Mittel (60 und 40) zum Aufsetzen des Deckels (13) im Verhältnis zum Boden (12) in der Querrichtung vorgesehen sind.

3. Gehäuse nach Anspruch 2, dadurch gekennzeichnet, daß die Mittel zum Aufsetzen des Deckels im Verhältnis zum Boden am Deckel bzw. am Boden befestigte elektrische Stift-und-Buchsen-Steckverbinder (60 und 40) zum Bereitstellen elektrischer Verbindungen zwischen dem Boden und am Deckel montierten elektrischen Bauteilen aufweisen.

4. Gehäuse nach Anspruch 3, dadurch gekennzeichnet, daß die Buchsen (40) in Hohlräumen (33) in einem am Boden (12) befestigten Isolierelement (30) montiert sind und jede Buchse (40) kleinere Abmessungen hat als der Hohlraum (33), in dem sie sitzt, so daß sie sich in begrenztem Maße bewegen kann, um kleine Abweichungen der Positionierung der Stifte (60) zuzulassen.

5. Gehäuse nach Anspruch 3 oder 4, dadurch gekennzeichnet, daß die Stifte (60) Rundstiftstecker sind, die in Buchsen mit rechteckigem oder sechseckigem Querschnitt gesteckt werden, wenn der Deckel auf den Boden gesenkt wird.

6. Gehäuse nach Anspruch 4 oder 5, gekennzeichnet durch eine Erdungsbuchse (45) und einen Erdungsstecker (60) am Deckel bzw. Boden und bei dem Erdungsbuchse (45) und -stecker (60) einander näher liegen als die anderen Buchsen (40) und Stecker (60), wenn Deckel und Boden getrennt sind, so daß sie beim Senken des Deckels (13) auf den Boden (12) als erste miteinander in Berührung kommen.

7. Gehäuse für ein elektrisches Bauteil, umfassend einen Boden (12) und einen Deckel (13), Einrastmittel zum Befestigen des Deckels am Boden, am Deckel (13) montierte elektrische Bauteile (50 bis 54) und Anschlußklemmen (34) zum Verbinden mit am Boden (12) montierten elektrischen Speisekabeln, wobei Stift-und-Buchsen-Steckverbinder (60 und 40) mit dem Stift (60) am Boden (12) oder am Deckel (13) und der Buchse (40) am Deckel bzw. am Boden versehen sind, wobei die Stift-und-Buchsen-Steckverbinder zum Aufsetzen des Deckels (13) im Verhältnis zum Boden (12) in der Querrichtung dienen und auch, um elektrische Verbindungen zwischen den Bauteilen (50 bis 54) und den Anschlußklemmen (34) herzustellen, wenn der Deckel (13) auf dem Boden (12) angebracht wird, wobei die Mittel zum Befestigen des Deckels am Boden Einrastmittel in der Form von mindestens zwei T-förmigen, von dem genannten Boden (12) nach oben ragenden Ansätzen (18) umfassen, die in entsprechenden Schlitzen (24) in Eingriff gebracht werden können, die in Flansche (23) geformt sind, welche sich von der Unterseite der Umfangsseitenwände des Deckels (13) erstrecken, wobei die Umfangswand des Bodens im Bereich der T-förmigen Ansätze niedriger ist, wobei die Oberseite der Ansätze (18) niedriger ist als die Oberseite der Umfangswand (15) des Bodens an ihrem höchsten Punkt (19), wodurch die von den Schlitzen (24) und den Ansätzen (18) gebildete Befestigungsanordnung unter der Höhe der Oberseite des Bodens angeordnet ist, und die längeren Teile der Schlitze sich auf der Seite der kürzeren Teile befinden, die sich am weitesten von der Umfangsseitenwand des Deckels entfernt befindet, die Buchsen (40) in Hohlräumen (33) in einem am Boden (12) oder Deckel (13) befestigten Isolierelement (30) montiert sind und jede Buchse (40) kleinere Abmessungen hat als der Hohlraum, in dem sie sitzt, so daß sie sich in begrenztem Maße bewegen kann, um kleine Abweichungen der Positionierung der Stifte (60) zuzulassen, wobei die seitliche Bewegung begrenzt und geringer ist als die seitliche Bewegung, die das Lösen der T-förmigen Ansätze ermöglichen würde.

## Revendications

1. Boîtier (1) de composant électrique, comprenant une base (12) et un couvercle (13), la base comportant une paroi de fond (14) et des parois périphériques (15 et 16) s'étendant vers le haut à partir de la paroi de fond (14), au moins deux languettes en forme de T (18) saillant vers le haut à partir de la base (12), et le couvercle comportant une paroi de dessus (13) et des parois périphériques (21 et 22) saillant vers le bas à partir de la paroi de dessus (13), des fentes (24) étant formées dans le couvercle et étant positionnées pour coopérer avec les languettes en forme de T (18), chaque fente (24) comportant des parties (24a et 24b) de longueur plus longue et plus courte disposées côte à côte, la longueur de la partie plus longue (24a) étant supérieure à la longueur de la traverse (18a) de la languette en forme de T correspondante (18) et la longueur de la partie plus courte (24b) étant inférieure à la longueur de la traverse (18a) mais supérieure à la largeur de la tige (18b) de la languette en forme de T (18), caractérisé en ce que la paroi périphérique (16) de la base est plus basse dans la région des languettes en forme de T, en ce que les dessus des languettes (18) sont plus bas que le dessus de la paroi périphérique (15) de la base à son point le plus haut (19), en ce que les fentes (24) sont formées sur des brides (23) s'étendant depuis le bas des parois latérales périphériques du couvercle (13), si bien que l'agencement de fixation formé par les fentes (24) et les languettes (18) est placé en dessous du niveau du dessus de la base, et en ce que les parties plus longues des fentes se trouvent sur le côté des parties plus courtes qui est le plus éloigné de la paroi latérale périphérique du couvercle.

2. Boîtier selon la revendication 1, caractérisé en ce que des moyens (60 et 40) sont fournis pour positionner le couvercle (13) par rapport à la base (12) dans le sens transversal.

3. Boîtier selon la revendication 2, caractérisé en ce que les moyens de positionnement du couvercle par rapport à la base comprennent des connecteurs électriques à contacts mâles et femelles (60 et 40) montés sur le couvercle et la base respectivement pour assurer des connexions électriques entre la base et les composants électriques montés sur le couvercle.

4. Boîtier selon la revendication 3, caractérisé en ce que les contacts femelles (40) sont montés dans des cavités (33) dans un élément isolant (30) fixé à la base (12) et chaque contact femelle (40) est de plus petites dimensions que la cavité (33) dans laquelle il repose de telle sorte qu'il puisse se déplacer d'une quantité limitée afin d'accepter de petites variations lors du positionnement des contacts mâles (60).

5. Boîtier selon la revendication 3 ou 4, caractérisé en ce que les contacts mâles (60) sont des fiches mâles à broches rondes qui s'engagent dans les contacts femelles de coupe transversale rectangulaire ou hexagonale quand le couvercle est abaissé sur la base.

6. Boîtier selon la revendication 4 ou 5, caractérisé par une contact de terre femelle (45) et un contact de terre mâle (60) sur le couvercle et la base respectivement et dans lequel les contacts de terre femelle (45) et mâle (60) sont plus proches l'un de l'autre que les autres contacts femelles (40) et contacts mâles (60) quand le couvercle et la base sont séparés, si bien qu'ils seront les premier à entrer en contact quand le couvercle (13) sera abaissé sur la base (12).

7. Boîtier de composant électrique, comprenant une base (12) et un couvercle (13), des moyens de verrouillage pour fixer le couvercle à la base, des composants électriques (50 à 54) étant montés sur le couvercle (13) et des bornes (34) pour la connexion à des câbles d'alimentation électrique étant montées sur la base (12), des connecteurs à contacts mâles et femelles (60 et 40) étant fournis avec le contact mâle (60) sur la base (12) ou le couvercle (13) et le contact femelle (40) sur le couvercle ou la base respectivement, les connecteurs à contacts mâles et femelles servant à positionner le couvercle (13) par rapport à la base (12) dans le sens transversal et aussi à assurer des connexions électriques entre les composants (50 à 54) et les bornes (34) quand le couvercle (13) est monté sur la base (12), les moyens de fixation du couvercle sur la base comprennent des moyens de verrouillage en forme d'au moins deux languettes en forme de T (18) saillant vers le haut à partir de ladite base (12) qui sont engageables dans des fentes respectives (24) formées sur des brides (23) s'étendant depuis le bas des parois latérales périphériques du couvercle (13), la paroi périphérique de la base étant plus basse dans la région des languettes en forme de T, les dessus des languettes (18) étant plus bas que le dessus de la paroi périphérique (15) de la base à son point le plus haut (19), si bien que l'agencement de fixation formé par les fentes (24) et les languettes (18) est placé en dessous du niveau du dessus de la base, et les parties plus longues des fentes se trouvent sur le côté des parties plus courtes qui est le plus éloigné de la paroi latérale périphérique du couvercle, les contacts femelles (40) sont montés dans des cavités (33) dans un élément isolant (30) fixé à la base (12) ou au couvercle (13), et chaque contact femelle (40) est de plus petites dimensions que la cavité dans laquelle il repose de telle sorte qu'il puisse se déplacer d'une quantité limitée pour accepter de petites variations lors du positionnement des broches (60), le déplacement latéral étant limité et inférieur au déplacement latéral qui permettrait aux languettes en forme de T de se détacher.
